# EUROPÄISCHE PATENTANMELDUNG

(11) **EP 3 297 047 A1**
(43) Veröffentlichungstag der Anmeldung: **21.03.2018**
(21) Anmeldenummer: 17190425.3
(22) Anmeldetag: 11.09.2017
(51) Int. Cl.: H01L 33/56, H05K 3/28

(54) **LEUCHTEINRICHTUNG FÜR LEUCHTMITTEL**

(30) Priorität: 12.09.2016 DE 202016105054 U
(71) Anmelder: RIDI Leuchten GmbH, 72417 Jungingen (DE)
(72) Erfinder: WECKERLE, Stefan, 72401 Haigerloch (DE)
(74) Vertreter: BRP Renaud & Partner mbB Rechtsanwälte Patentanwälte Steuerberater

(57) **Zusammenfassung**

Die vorliegende Erfindung betrifft eine Leuchteinrichtung (1) für ein Leuchtmittel. Die Leuchteinrichtung (1) umfasst eine Leiterplatte (2), auf deren Vorderseite wenigstens eine LED (4) angeordnet ist. Auf der Vorderseite (3) der Leiterplatte (2) ist eine Schutzbeschichtung (5) vorhanden, welche zumindest die wenigstens eine LED (4) überdeckt und das von der LED (4) abgestrahlte Licht transmittiert.

## Beschreibung

Die vorliegende Erfindung betrifft eine Leuchteinrichtung für ein Leuchtmittel einer Leuchte. Die Erfindung betrifft außerdem ein mit einer derartigen Leuchteinrichtung ausgestattetes Leuchtmittel für eine Leuchte.

Energiesparende moderne Leuchtmittel verwenden Leuchteinrichtungen, die Licht mit Hilfe von lichtemittierenden Dioden, kurz LED, erzeugen. Typischerweise werden solche LED auf einer Leiterplatte - dem einschlägigen Fachmann auch als "Leiterplatte" bekannt - angeordnet, von welcher sie wie gewünscht Licht abstrahlen können. Eine solche Leiterplatte erlaubt eine einfache elektrische Verdrahtung der LED, um diese mit elektrischer Energie aus einer externen elektrischen Energiequelle versorgen zu können. Die elektrische Verdrahtung kann in Form von elektrischen Leiterbahnen erfolgen, die auf die Leiterplatte in bekannter Weise aufgebracht werden. Solche Leiterbahnen sind auf der Leiterplatte in üblicher Weise durch Materialabtragung einer elektrisch leitenden Beschichtung der Leiterplatte ausgebildet. Somit lassen sich die Leiterbahnen besonders preiswert auf der Leiterplatte im Rahmen einer Großserienfertigung herstellen. Bevorzugt wird hierbei eine Metallleiterplatte, also eine Leiterplatte mit Metallkern, z.B. aus einer Aluminiumlegierung oder aus einer Kupferlegierung, als Trägersubstrat. Bei einer solchen Metalleiterplatte ist die vorstehend genannte elektrisch leitende Beschichtung elektrisch durch eine elektrisch isolierende Trenn- oder Isolationsschicht vom Metallkern getrennt. Mithilfe einer solchen Metallleiterplatte lassen sich besonders hohe elektrische Leistungen realisieren, da Wärme, die damit einhergeht, relativ gut abgeleitet werden kann. Die Leiterbahnen können die LED mit geeigneten, ebenfalls auf der Leiterbahn vorhandenen elektrischen Kontakten verbinden, über welche der elektrische Anschluss an besagte externe elektrische Energiequelle erfolgt.

Als nachteilig bei derart ausgebildeten Leuchteinrichtungen mit auf Leiterplatten angeordneten LED erweist sich, dass die LED im Langzeitbetrieb typischerweise erheblichen äußeren Einflüssen wie etwa Schmutz, Feuchtigkeit oder Schadgasen ausgesetzt werden kann, was zu einem beschleunigten Verschleiß bis hin zur Beschädigung oder gar Zerstörung der Leuchteinrichtung führen können.

Die vorliegende Erfindung beschäftigt sich mit dem Problem, für eine Leuchteinrichtung bzw. für ein damit ausgestattetes Leuchtmittel eine verbesserte Ausführungsform anzugeben, die sich durch eine erhöhte Lebensdauer und durch einen verbesserten Schutz gegen Beschädigung oder gar Zerstörung auszeichnet.

Dieses Problem wird erfindungsgemäß durch den Gegenstand des unabhängigen Anspruchs gelöst. Vorteilhafte Ausführungsformen sind Gegenstand der abhängigen Ansprüche.

Eine erfindungsgemäße Leuchteinrichtung für ein Leuchtmittel umfasst eine Leiterplatte, auf deren Vorderseite wenigstens eine Licht emittierende LED angeordnet. Bevorzugt sind mehrere solche LED vorgesehen. Als "Vorderseite" wird vorliegend eine der beiden Oberflächen der Leiterplatte, die auch - je nach Gebrauchslage der Leuchteinrichtung - als Oberseite oder Unterseite bezeichnet werden mag, angesehen. Auf der Vorderseite der Leiterplatte ist erfindungsgemäß eine Schutzbeschichtung angeordnet, welche zumindest die wenigstens eine LED überdeckt und dabei das von der LED abgestrahlte Licht transmittiert. Mittels einer solchen Schutzbeschichtung kann die LED gegen Beschädigung oder Zerstörung durch Verschmutzung und Korrosion, hervorgerufen insbesondere durch Feuchtigkeit oder Schadgase, geschützt werden. Auf diese Weise kann die Lebensdauer der Leuchteinrichtung gegenüber herkömmlichen Leuchteinrichtungen ohne eine solche Schutzbeschichtung signifikant erhöht werden. Dabei wird durch die transparenten Eigenschaften der Schutzbeschichtung sichergestellt, dass optischen Eigenschaften der Leuchteinrichtung nicht beeinträchtigt werden und insbesondere zumindest ein Großteil des von der LED abgestrahlten Lichts nicht durch die Schutzbeschichtung absorbiert und/oder reflektiert, sondern transmittiert wird, sodass nahezu das gesamte von der LED abgestrahlte Licht wie gewünscht in die Umgebung der Leuchteinrichtung austreten kann.

Bevorzugt ist die Leiterplatte länglich und flach ausgebildet. Die relative Angabe "länglich" besagt dabei, dass eine Länge der Leiterplatte deutlich, also mindestens zwei Mal und vorzugsweise mindestens fünf Mal größer ist als eine Breite und eine Dicke der Leiterplatte. Die relative Angabe "flach" ist so zu verstehen, dass eine Dicke der flachen Leiterplatte deutlich, also mindestens fünf Mal kleiner ist als eine Breite und eine Länge der Leiterplatte.

Gemäß einer bevorzugten Ausführungsform umfasst oder ist die Schutzbeschichtung eine Lackschicht. Eine solche Lackschicht besitzt einerseits die erforderlichen optischen Eigenschaften, d.h. sie ist bei geeigneter Zusammensetzung für das von der LED abgestrahlte Licht nahezu vollständig transparent, stellt aber andererseits aufgrund ihrer Materialeigenschaften auch die gewünschte Schutzwirkung gegen Verschmutzung bzw. Korrosion der überdeckten LED sicher. Gleichzeitig ist eine solche Lackschicht aufgrund ihrer typischerweise hohen Viskosität mithilfe einer geeigneten Beschichtungsanlage - insbesondere unter Verwendung eines geeigneten Dispenserkopfes - sehr gut dazu geeignet, gezielt lokal auf die einzelnen LED aufgebracht zu werden. Auch eine unerwünschte Beschichtung von Bereichen der Leiterplatte, auf welchen keine LED vorhanden sind, kann auf diese Weise vermieden werden.

Bevorzugt überdeckt die Lackschicht nicht nur die wenigstens eine LED, sondern zusätzlich auch eine Oberflächenzone der Leiterplatte, welche die wenigstens eine LED umlaufend einfasst. Auf diese Weise werden nicht nur die auf der Leiterplatte angeordnete LED, sondern auch die dazu komplementären Bereiche der Leiterplatte gegen Beschädigung oder gar Zerstörung durch Verschleiß, Korrosion, Verschmutzung usw. geschützt.

Zweckmäßig kann besagte Oberflächenzone eine laterale Schichtbreite zwischen 2 mm und 5 mm aufweisen. Auf diese Weise ist sichergestellt, dass nicht nur die Oberseite der LED, sondern auch die Umfangsseiten der LED mittels der Schutzbeschichtung geschützt werden.

Bei einer vorteilhaften Weiterbildung besteht die Lackschicht aus einem elektrisch isolierenden Kunststoff und enthält Polyurethan und Polyacrylat. Eine aus diesem Material gebildete Lackschicht ist besonders einfach auf die Leiterplatte bzw. die LED auf zu bringen und weist hinsichtlich des angestrebten Schutzes der LED gegen Beschädigung bzw. Verschleiß hervorragende Eigenschaften auf.

Bei einer anderen vorteilhaften Weiterbildung beträgt eine auf der Vorderseite der LED gemessene Schichtdicke der Lackschicht zwischen 100 µm und 300 µm. Mittels der auf diese Weise erzeugten Dicklackschicht wird einerseits sichergestellt, dass die Lackschicht hinreichend dick ausgebildet ist, um dauerhaft die gewünschte Schutzwirkung sicherzustellen. Insbesondere wird verhindert, dass durch einfache Kratzer oder ähnliches die Schutzschicht auf unerwünschte Weise von der LED entfernt wird. Andererseits wird durch den genannten Schichtdickenbereich auch eine hinreichend große Transmission des von der LED abgestrahlten Lichts durch die Lackschicht hindurch gewährleistet.

Besonders bevorzugt emittiert die zumindest eine LED Licht mit einer ersten Lichtfarbe, welches von der Lackschicht in Licht mit einer zweiten Lichtfarbe umgewandelt wird. Hierbei weist die zweite Lichtfarbe eine höhere Farbtemperatur auf als die erste Lichtfarbe. Bei einer vorteilhaften Weiterbildung beträgt dabei eine Verschiebung der Farbtemperatur von der ersten Lichtfarbe zur zweiten Lichtfarbe zwischen 10% und 30% der Farbtemperatur der ersten Lichtfarbe. Dies gilt insbesondere, wenn als Schutzbeschichtung eine Lackschicht gewählt wird.

Gemäß einer anderen bevorzugten Ausführungsform enthält die Schutzbeschichtung ein Fluoacrylatpolymer, welches mit einem Lösungsmittel verdünnt ist. Auch eine derart ausgebildete Schutzbeschichtung besitzt die gewünschten Eigenschaften zur Vermeidung einer Beschädigung oder gar Zerstörung der LED durch Verschmutzung oder Korrosion im Langzeitbetrieb.

Bei einer vorteilhaften Weiterbildung enthält oder ist das Lösungsmittel Hydrofluoerether.

Bei einer vorteilhaften Weiterbildung überdeckt die Schutzbeschichtung zumindest die Vorderseite der Leiterplatte vollständig. Auf diese Weise kann die von der Schutzbeschichtung erzeugte Schutzwirkung auch auf besagte Vorderseite ausgedehnt werden, auf welcher insbesondere Leiterbahnen und weitere elektrische Komponenten angeordnet sein können. Auch diese Komponenten werden somit von der Schutzbeschichtung gegen Verschleiß und Beschädigung, insbesondere durch Korrosion, geschützt.

Bei einer besonders bevorzugten Weiterbildung überdeckt die Schutzbeschichtung nicht nur die Vorderseite, sondern alle Außenseiten der Leiterplatte - einschließlich der Vorder- und Rückseite - vollständig. Auf diese Weise kann die von der Schutzbeschichtung erzeugte Schutzwirkung auf die komplette Leiterplatte einschließlich aller darauf angeordneten Komponenten erweitert werden. Dies kann erreicht werden, in dem die Leiterplatte in ein Tauchbad der Schutzbeschichtung eingetaucht wird.

Besonders zweckmäßig kann eine Schichtdicke der Schutzbeschichtung zwischen 0,3 µm und 0,8 µm, vorzugsweise ungefähr 0,5 µm betragen.

Bevorzugt strahlt die zumindest eine LED Licht mit einer ersten Lichtfarbe ab, welches von der Schutzbeschichtung in Licht mit einer zweiten Lichtfarbe umgewandelt wird. Dabei weist die zweite Lichtfarbe eine höhere Farbtemperatur auf als die erste Lichtfarbe. Dies bedeutet, dass die Farbe des Lichts von der Schutzbeschichtung in Richtung "kalt" verschoben wird. Die Schutzbeschichtung kann also dazu herangezogen werden, die Farbeigenschaften der LED, zumindest in geringfügige Maße, zu modifizieren.

Besonders zweckmäßig beträgt eine Verschiebung der Farbtemperatur von der ersten Farbe zur zweiten Farbe durch die Schutzbeschichtung höchstens 3% der Farbtemperatur der ersten Farbe. Auf diese Weise wird sichergestellt, dass eine zu große, unerwünschte Änderung der von der LED ursprünglich abgestrahlten Lichtfarbe durch die Schutzbeschichtung vermieden wird.

Bei einer vorteilhaften Weiterbildung sind auf der Vorderseite der Leiterplatte mehrere LED entlang einer Längserstreckungsrichtung benachbart zueinander angeordnet, elektrisch miteinander verbunden und jeweils mit der Schutzbeschichtung überdeckt. Die erfindungswesentliche Schutzbeschichtung eignet sich also auch bei komplexer aufgebauten Leuchteinrichtungen mit mehreren LED als Schutz gegen eine unerwünschte Beschädigung der LED durch Verschmutzung und Feuchtigkeit.

Zweckmäßig ist die Schutzbeschichtung, insbesondere die Lackschicht, für das von der zumindest einen LED abgestrahlte Licht transparent. Hierbei besitzt die Schutzbeschichtung bzw. die Lackschicht vorzugsweise einen Transmissionsgrad von wenigstens 95%, höchst vorzugsweise von wenigstens 98%. Auf diese Weise wird die Leuchteffizienz der LED durch die Schutzbeschichtung nicht oder nur in unerheblichem Maße beeinträchtigt.

Die Erfindung betrifft außerdem ein Leuchtmittel für eine Leuchte. Das Leuchtmittel umfasst ein Gehäuse, in welchem die vorangehend vorgestellte Leuchteinrichtung angeordnet ist. Die vorangehend erläuterten Vorteile der Leuchteinrichtung übertragen sich daher auch auf das erfindungsgemäße Leuchtmittel.

Gemäß einer bevorzugten Ausführungsform weist das Gehäuse einen Kühlkörper auf, an dem die Leiterplatte mit einer von der zumindest einen LED abgewandten Rückseite flächig anliegt. Hierdurch kann die im Betrieb der LEDs anfallende Wärme über die Rückseite der Leiterplatte an den Kühlkörper abgegeben werden, der die Wärme dann seinerseits ableitet und insbesondere in eine Umgebung abstrahlen kann. Bevorzugt ist eine Ausführungsform, bei welcher die Leiterplatte mit ihrer Rückseite vorgespannt am Kühlkörper zur Anlage kommt. Eine derartige Vorspannung kann beispielsweise über seitliche Haltemittel in die Leiterplatte eingeleitet werden, die insbesondere die Seitenränder der Leiterplatte übergreifen. Alternativ dazu kann die Leiterplatte auch mittels Schraubverbindungen am Kühlkörper befestigt sein.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: ein erstes Beispiel einer erfindungsgemäßen Leuchteinrichtung in einer schematischen und stark vereinfachten Darstellung,
- Fig. 2: ein zweites Beispiel der erfindungsgemäßen Leuchteinrichtung in einer schematischen und stark vereinfachten Darstellung.

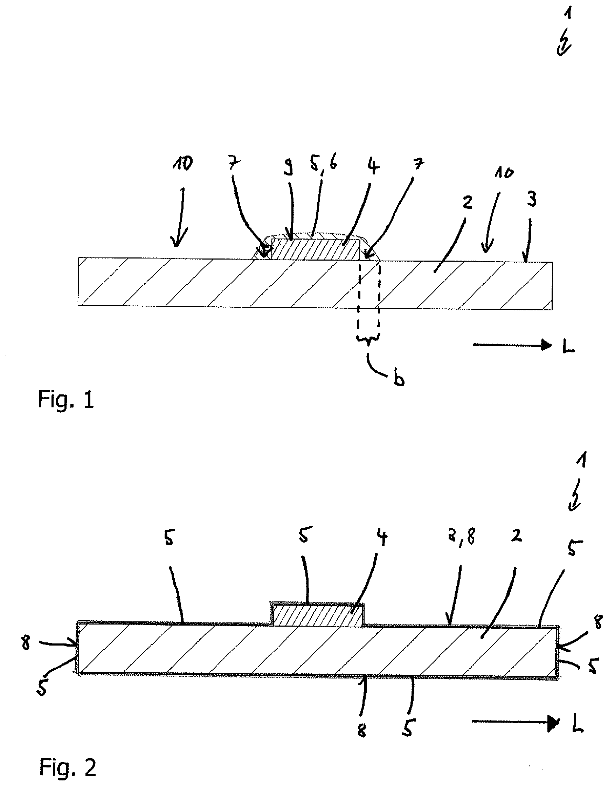

Entsprechend Figur 1 umfasst eine Leuchteinrichtung 1 eine Leiterplatte 2, die die hier länglich und flach ausgestaltet ist. Die relative Angabe "länglich" besagt dabei, dass eine Länge der Leiterplatte 2 deutlich, also mindestens zweimal Mal und vorzugsweise mindestens fünf Mal größer ist als eine Breite und eine Dicke der Leiterplatte 2. Die relative Angabe "flach" ist so zu verstehen, dass eine Dicke der flachen Leiterplatte deutlich, also mindestens fünf Mal kleiner ist als eine Breite und eine Länge der Leiterplatte 2. Die Leiterplatte 2 kann darüber hinaus auch eben und gerade ausgebildet sein.

Auf einer Vorderseite 3 der Leiterplatte 2 sind lichtemittierende Dioden, kurz LED, 4 angeordnet. Im Beispiel der Figur 1 ist der Übersichtlichkeit halber nur eine einzige solche LED 4 gezeigt. Auf der Vorderseite 3 können mehrere solche LED 4 entlang einer Längserstreckungsrichtung L benachbart zueinander angeordnet sein.

Die LED 4 ist zur Abstrahlung von Licht mit einer ersten Lichtfarbe, ausgestaltet. Beispielsweise kann die erste Lichtfarbe ein warmweißes Weißlicht mit einer Farbtemperatur von ca. 3.000 K sein. Die LED 4 kann mit Hilfe von in der Leiterplatte 2 ausgebildeten und in der Figur 1 nicht näher dargestellten Leiterbahnen elektrisch mit einer externen elektrischen Energiequelle verbunden werden, welche die LED 4 mit elektrischer Energie versorgt, so dass diese wie gewünscht Licht erzeugt. Die LED 4 können durch die Leiterbahnen elektrisch in Reihe geschaltet sein.

Wie Figur 1 erkennen lässt, ist auf der Vorderseite der Leiterplatte 2 eine Schutzbeschichtung 5 vorgesehen, welche die LED 4 überdeckt. Im Beispiel der Figur 1 ist die Schutzbeschichtung 5 eine Lackschicht 6. Die Schutzbeschichtung 5 bzw. die Lackschicht 6 überdeckt entsprechend Figur 1 auch eine die LED 4 umlaufend einfassende Oberflächenzone 7 der Leiterplatte 2. Die Oberflächenzone 7 weist eine lateral zur Vorderseite 3 gemessene, laterale Schichtbreite b zwischen 2mm und 5mm auf.

Die Lackschicht 6 besteht aus einem elektrisch isolierenden Kunststoff, der Polyurethan und Polyacrylat enthält. Auf einer von der Leiterplatte 2 abgewandten Vorderseite 9 der LED 4, von welcher weg das Licht emittiert wird, beträgt die Schichtdicke der Lackschicht 6 zwischen 100µm und 300µm.

Die Lackschicht 6 kann mittels einer Beschichtungsanlage, die einen geeigneten Dispenser aufweist, gezielt auf die Leiterplatte 2 aufgebracht werden. Dies erlaubt eine Beschichtung der Leiterplatte 2 derart, dass nur die Vorderseiten 9 der LED 4 einschließlich der erwähnten Oberflächenzonen 7 mit der Lackschicht 6 lokal beschichtet werden. Die verbleibenden Bereiche 10 der Vorderseite 3 der Leiterplatte 2 bleiben hingegen frei von der Lackschicht 6, d.h. in diesen Bereichen ist keine Lackschicht 6 vorhanden.

Die LED 4 strahlt Licht mit einer ersten Lichtfarbe ab, welches von der Lackschicht 6 in Licht mit einer zweiten Lichtfarbe umgewandelt wird. Die zweite Lichtfarbe weist dabei eine höhere Farbtemperatur auf als die erste Lichtfarbe. Die auf diese Weise erzeugte eine Verschiebung der Farbtemperatur von der ersten Lichtfarbe zur zweiten Lichtfarbe beträgt zwischen 10% und 30% der Farbtemperatur der ersten Lichtfarbe. Die Lackschicht ist für das von der LED 4 abgestrahlte Licht der ersten Lichtfarbe transparent und besitzt dabei einen Transmissionsgrad von wenigstens 95%, vorzugsweise von wenigstens 98%.

Die Figur 2 zeigt eine Variante der Leuchteinrichtung 1 der Figur 1. Bei der Leuchteinrichtung 1 gemäß Figur 2 ist die Schutzbeschichtung 5 nicht als Lackschicht 6 realisiert. Vielmehr basiert die Schutzbeschichtung 5 hier auf einer Flüssigkeit mit geringer Viskosität. Die Schutzbeschichtung 5 enthält ein Fluoacrylatpolymer, welches mit einem Lösungsmittel verdünnt ist. Das Lösungsmittel kann insbesondere Hydrofluoerether sein.

Die Schutzbeschichtung 5 kann durch Eintauchen der Leiterplatte 2 in ein Tauchbad auf die Leiterplatte 2 aufgebracht werden. Nach einem solchen Eintauchen überdeckt die Schutzbeschichtung 5 nicht nur die Vorderseite 3 der Leiterplatte 2, sondern alle Außenseiten 8 der Leiterplatte 2 flächig und vollständig. Auch die Vorderseite 3 der Leiterplatte 2 ist also entsprechend Figur 2 flächig und vollständig - und nicht nur lokal im Bereich der LED 4 wie im Beispiel der Figur 1 - von der Schutzbeschichtung 5 überdeckt.

Bei der Leuchteinrichtung 1 gemäß Figur 2 beträgt die Schichtdicke der Schutzbeschichtung 5 zwischen 0,3 µm und 0,8 µm. Vorzugsweise beträgt die Schichtdicke ungefähr 0,5 µm. Die von der Schutzbeschichtung 5 bewirkte eine Verschiebung der Farbtemperatur von der ersten Lichtfarbe zur zweiten Lichtfarbe ist bei der Schutzbeschichtung gemäß Figur 2 wesentlich geringer als bei der als Lackschicht 6 ausgebildeten Schutzbeschichtung 5 gemäß Figur 1 und beträgt höchstens 3% der Farbtemperatur der ersten Lichtfarbe, die von der LED 4 abgestrahlt wird.

## Patentansprüche

1. Leuchteinrichtung (1) für ein Leuchtmittel,
- mit einer, vorzugsweise länglichen und flachen, Leiterplatte (2), auf deren Vorderseite (3) wenigstens eine LED (4) angeordnet ist,
- wobei auf der Vorderseite (3) der Leiterplatte (2) eine Schutzbeschichtung (5) zum Schutz der LED (4), insbesondere gegen Schmutzpartikel, Feuchtigkeit sowie Schadgase, vorhanden ist, welche zumindest die wenigstens eine LED (4) überdeckt und das von der LED (4) abgestrahlte Licht transmittiert.

2. Leuchteinrichtung nach Anspruch 1,
**dadurch gekennzeichnet, dass**
die Schutzbeschichtung (5) eine Lackschicht (6) umfasst oder ist.

3. Leuchteinrichtung nach Anspruch 2,
**dadurch gekennzeichnet, dass**
die Lackschicht (6) zusätzlich eine Oberflächenzone (7) der Leiterplatte (2) überdeckt, welche die wenigstens eine LED (4) umlaufend einfasst.

4. Leuchteinrichtung nach Anspruch 3,
**dadurch gekennzeichnet, dass**
die Oberflächenzone (7) eine laterale Schichtbreite (b) zwischen 2 mm und 5 mm aufweist.

5. Leuchteinrichtung nach einem der Ansprüche 2 bis 4,
**dadurch gekennzeichnet, dass**
die Lackschicht (6) aus einem elektrisch isolierenden Kunststoff besteht und Polyurethan und Polyacrylat enthält.

6. Leuchteinrichtung nach einem der Ansprüche 2 bis 5,
**dadurch gekennzeichnet, dass**
eine auf der Vorderseite (9) der LED (4) gemessene Schichtdicke der Lackschicht zwischen 100 µm und 300 µm beträgt.

7. Leuchteinrichtung nach einem der vorhergehenden Ansprüche,
**dadurch gekennzeichnet, dass**
die zumindest eine LED (4) Licht mit einer ersten Lichtfarbe emittiert, welches von der Lackschicht (6) in Licht mit einer zweiten Lichtfarbe umgewandelt wird, wobei die zweite Lichtfarbe eine höhere Farbtemperatur aufweist als die erste Lichtfarbe.

8. Leuchteinrichtung nach Anspruch 7,
**dadurch gekennzeichnet, dass**
eine Verschiebung der Farbtemperatur von der ersten Lichtfarbe zur zweiten Lichtfarbe zwischen 10% und 30% der Farbtemperatur der ersten Lichtfarbe beträgt.

9. Leuchteinrichtung nach Anspruch 1,
**dadurch gekennzeichnet, dass**
die Schutzbeschichtung (5) ein Fluoacrylatpolymer enthält, welches mit einem Lösungsmittel verdünnt ist.

10. Leuchteinrichtung nach Anspruch 9,
**dadurch gekennzeichnet, dass**
das Lösungsmittel Hydrofluoerether enthält oder Hydrofluoerether ist.

11. Leuchteinrichtung nach Anspruch 9 oder 10,
**dadurch gekennzeichnet, dass**
die Schutzbeschichtung (5) zumindest die Vorderseite der Leiterplatte (2) vollständig überdeckt.

12. Leuchteinrichtung nach einem der Ansprüche 9 bis 11,
**dadurch gekennzeichnet, dass**
die Schutzbeschichtung (5) alle Außenseiten (8) der Leiterplatte (2) vollständig überdeckt.

13. Leuchteinrichtung nach einem der Ansprüche 9 bis 12,
**dadurch gekennzeichnet, dass**
eine Schichtdicke der Schutzbeschichtung (5) zwischen 0,3 µm und 0, 8 µm, vorzugsweise ungefähr 0,5µm beträgt.

14. Leuchteinrichtung nach einem der Ansprüche 9 bis 13,
**dadurch gekennzeichnet, dass**
die zumindest eine LED (4) Licht mit einer ersten Lichtfarbe emittiert, welches von der Schutzbeschichtung (5) in Licht mit einer zweiten Lichtfarbe umgewandelt wird, wobei die zweite Lichtfarbe eine höhere Farbtemperatur aufweist als die erste Lichtfarbe.

15. Leuchteinrichtung nach Anspruch 14,
**dadurch gekennzeichnet, dass**
eine Verschiebung der Farbtemperatur von der ersten Farbe zur zweiten Farbe höchstens 3% der Farbtemperatur der ersten Farbe beträgt.

16. Leuchteinrichtung nach einem der vorhergehenden Ansprüche,
**dadurch gekennzeichnet, dass**
auf der Vorderseite (3) der Leiterplatte (2) mehrere LED (4) entlang einer Längserstreckungsrichtung (L) benachbart zueinander angeordnet, elektrisch miteinander verbunden und jeweils mit der Schutzbeschichtung (5) überdeckt sind.

17. Leuchteinrichtung nach einem der vorhergehenden Ansprüche,
**dadurch gekennzeichnet, dass**
die Schutzbeschichtung (5), insbesondere die Lackschicht (6), für das von der zumindest einen LED (4) abgestrahlte Licht transparent ist und vorzugsweise einen Transmissionsgrad von wenigstens 95%, höchst vorzugsweise von wenigstens 98%, besitzt.

18. Leuchtmittel für eine Leuchte,
mit einer Leuchteinrichtung (1) nach einem der vorhergehenden Ansprüche und mit einem Gehäuse, in welchem die Leuchteinrichtung (1) aufgenommen ist.

19. Leuchtmittel nach Anspruch 18,
**dadurch gekennzeichnet,**
**dass** das Gehäuse (28) einen Kühlkörper aufweist, an dem die Leiterplatte mit einer von der zumindest einen LED (4) abgewandten Rückseite flächig anliegt.
